# EUROPEAN PATENT APPLICATION

(11) **EP 4 340 031 A1**
(43) Date of publication of application: **20.03.2024**
(21) Application number: 22825150.0
(22) Date of filing: 03.05.2022
(51) Int. Cl.: H01L 27/32, H01L 51/52, G02F 1/1345, G02F 1/1335

(54) **DISPLAY AND ELECTRONIC DEVICE COMPRISING SAME**

(30) Priority: 15.06.2021 KR 20210077653
(71) Applicant: Samsung Electronics Co., Ltd., Suwon-si, Gyeonggi-do 16677 (KR)
(72) Inventor: KIM, Namhyung, Suwon-si Gyeonggi-do 16677 (KR); YOON, Jeonggen, Suwon-si Gyeonggi-do 16677 (KR); LIM, Kiyul, Suwon-si Gyeonggi-do 16677 (KR); HEO, Gyun, Suwon-si Gyeonggi-do 16677 (KR); HONG, Soonmin, Suwon-si Gyeonggi-do 16677 (KR)
(74) Representative: Nederlandsch Octrooibureau
(86) International application number: PCT/KR2022/006299
(87) International publication number: WO 2022/265222

(57) **Abstract**

According to various embodiments disclosed in the present document, a display and/or an electronic device comprising same may comprise: at least one substrate; at least one signal line which, at the edge of the substrate, is formed on at least the side surface of the substrate among the front, rear, and side surfaces of the substrate; and a printing layer which, at the edge of the substrate, is formed to cover at least a part of the signal line, wherein the printing layer is configured to be transparent or translucent so as to visually expose at least a part of the signal line to the outside. Various other embodiments are also possible.

## Description

### [Technical Field]

Various embodiments disclosed herein relate to an electronic device, for example, an electronic device including a display.

### [Background Art]

Various types of electronic devices are used in daily life with the development of electronic and communication technologies. Video devices or mobile phones provided video and audio call functions in the early days, and developments in flat panel displays and communication technology have led user devices to provide additional functionalities through network or other electronic device connections. The development of display technology has made it possible for video devices such as televisions to be implemented in the form of a flat panel that is thin and light enough to be attached to a wall and for portable electronic devices to be more portable by means of integration with a touch panel so as to replace mechanical input device such as keypads with displays.

As ultra-high-definition video services and real-time streaming services using the electronic devices become more popular, the degree of integration of signal line that transmits or supplies input/output signals, various control signals, or power may be increased. On the other hand, by increasing the ratio of the screen display area to the actual surface area in the exterior of the electronic device, the aesthetic impression of the electronic device may be achieved while providing a larger screen. For example, by reducing the bezel around the screen display area, the degree of immersion in the screen may be increased, and the size and weight of the electronic device may be easily reduced.

### [Detailed Description of the Invention]

### [Technical Problem]

A bezel may be used as a space or area in which signal lines for control signals or power supply of a display are arranged. For example, a space or area capable of concealing signal lines from the outside of the electronic device while arranging the signal lines may be substantially provided in the bezel. However, in an environment in which expansion of signal lines is inevitable for high-capacity and high-speed transmission in signal transmission, such as ultra-high-definition video service, the narrowness of the bezel may result in a limitation of space or area for signal lines.

Various embodiments disclosed herein may provide a display capable of securing a space or area for signal lines while reducing a bezel and/or an electronic device including the display.

Various embodiments disclosed herein may provide a display including signal lines which is easy in manufacturing and improved in reliability and/or an electronic device including the display.

### [Technical Solution]

According to various embodiments disclosed herein, a display and/or an electronic device including same may include at least one substrate, at least one signal line which, at the edge of the substrate, is disposed on at least the side surface of the substrate among the front surface, the rear surface, and the side surface of the substrate, and a printed layer disposed to cover at least a portion of the signal line at the edge of the substrate, wherein the printed layer is configured to be transparent or translucent so as to visually expose at least a portion of the signal line to the outside.

According to various embodiments disclosed herein, an electronic device may include a housing and a display disposed on a surface of the housing, wherein the display includes at least one substrate, at least one signal line which, at the edge of the substrate, is disposed on at least the side surface of the substrate among the front, rear, and side surfaces of the substrate, and a printed layer disposed to cover at least a portion of the signal line at the edge of the substrate, wherein the printed layer is configured to be transparent or translucent so as to visually expose at least a portion of the signal line to the outside.

### [Advantageous Effects]

According to various embodiments disclosed herein, a display and/or an electronic device may secure a space or area in which a signal line may be disposed even when a bezel becomes narrow by providing the signal line by using a side surface of a substrate such as a circuit board, a polarization plate, and/or a glass plate. For example, the display and/or the electronic device according to various embodiments may easily reduce the bezel and provide a more extended screen display area. In an embodiment, even when the size of the bezel is reduced, the display and/or the electronic device according to various embodiments may secure a space or area for arranging the signal line, thereby increasing performance corresponding to an ultra-high-definition video service. In another embodiment, in a procedure in which a portion of a metal layer is removed to configure a signal line, a printed layer may be used as an etching mask to protect the signal line, and may be configured by a transparent or translucent material provide an environment in which the signal line is configured and then defects in the signal line may be identified by using an optical device or the naked eye. For example, the printed layer may contribute to improving the production efficiency or reliability of the signal line, the display, and/or the electronic device. In addition, various effects directly or indirectly identified through the disclosure may be provided.

### [Brief Description of Drawings]

FIG. 1 is a view illustrating a line structure of a display and/or electronic device according to various embodiments disclosed herein.
FIG. 2 is a sectional configuration view illustrating a line structure of a display and/or electronic device according to various embodiments disclosed herein.
FIG. 3 is a sectional configuration view illustrating a signal line in a line structure of a display and/or electronic device according to various embodiments disclosed herein.
FIG. 4 is a view illustrating a metal layer for configuring a signal line of a display and/or electronic device according to various embodiments disclosed herein.
FIG. 5 is a view illustrating an example in which a printed layer or an etching mask is disposed on the metal layer of FIG. 4.
FIG. 6 is a sectional configuration view illustrating an example in which a printed layer or an etching mask is disposed on a metal layer of FIG. 4.
FIG. 7 is a view illustrating an example in which a portion of a metal layer is removed by using a printed layer or an etching mask.
FIG. 8 is a sectional configuration view illustrating a shape in which a signal line of a display and/or electronic device is configured according to various embodiments disclosed herein.
FIG. 9 is a sectional configuration view illustrating another shape in which a signal line of a display and/or electronic device is configured according to various embodiments disclosed herein.
FIG. 10 is a planar view illustrating an example of a printed layer viewed from the outside of a substrate of a display and/or electronic device according to various embodiments disclosed herein.
FIG. 11 is a view illustrating an example in which a protection layer of a display and/or electronic device is configured according to various embodiments disclosed herein.
FIG. 12 is a sectional configuration view illustrating an example in which a protection layer of a display and/or electronic device is configured according to various embodiments disclosed herein.
FIG. 13 is a view illustrating an electronic device according to various embodiments disclosed herein.

### [Mode for Carrying out the Invention]

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in various embodiments of the disclosure, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

Various embodiments of the disclosure may be implemented as software (e.g., a program) including one or more instructions that are stored in a storage medium (e.g., an internal memory or external memory) that is readable by a machine (e.g., an electronic device). For example, a processor (e.g., a processor) of the machine (e.g., an electronic device) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

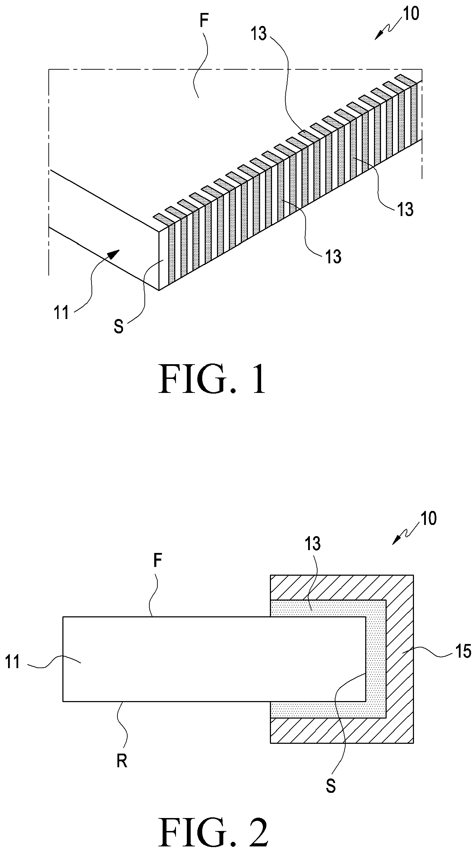

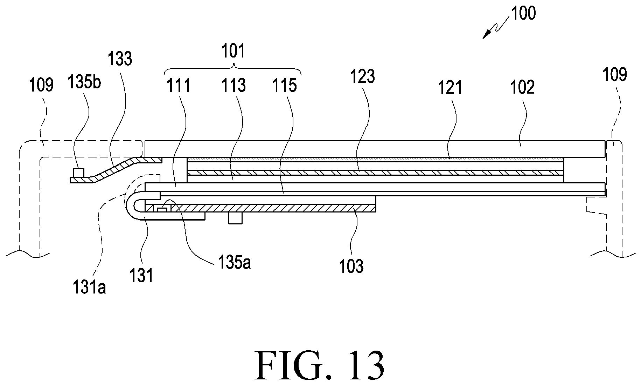

FIG. 1 is a view illustrating a line structure 10 of a display and/or electronic device (e.g., the display or electronic device 100 in FIG. 13) according to various embodiments disclosed herein. FIG. 2 is a sectional configuration view illustrating a line structure 10 of a display and/or electronic device 100 according to various embodiments disclosed herein.

Referring to FIG. 1 and FIG. 2, the display and/or electronic device (e.g., the electronic device 100 in FIG. 13) or the line structure 10 thereof may include a substrate 11 such as a circuit board, a polarization plate, and/or a glass plate (e.g., the first circuit board 111, the polarization plate 123, and/or the glass plate 102 in FIG. 13) and at least one signal line 13 disposed on the substrate 11. According to an embodiment, in case that the substrate 11 corresponds to a circuit board, a signal line 13 may be electrically connected to a printed circuit pattern disposed along a trajectory and a designated position on a surface (e.g., the front surface or the rear surface of the substrate) and/or on internal layers of the substrate 11. In a substrate such as the polarization plate 123 or the glass plate 102, the signal line 13 may be disposed on a surface (e.g., the side surface S and/or the front surface F or the rear surface R) of the substrate 11. In some embodiments, at least a portion of the signal line 13 may be disposed on the side surface S among the front surface F, the rear surface R, and/or the side surface S of the substrate 11 and another portion of the signal line 13 may be disposed on the front surface F or the rear surface S and electrically connected to the portion disposed on the side surface S. For example, in various embodiments disclosed herein, the signal line 13 may be disposed on the side surface S of the substrate 11 and thus a sufficient space for arranging a signal line 13 may be secured while reducing a bezel of the display and/or electronic device 100. In another embodiment, in the circuit board in which a printed circuit pattern is disposed on a surface (the front surface F or the rear surface R) or an internal layer, the signal line 13 may be disposed on the side surface S and in this case, the signal line 13 may be electrically connected to the printed circuit pattern.

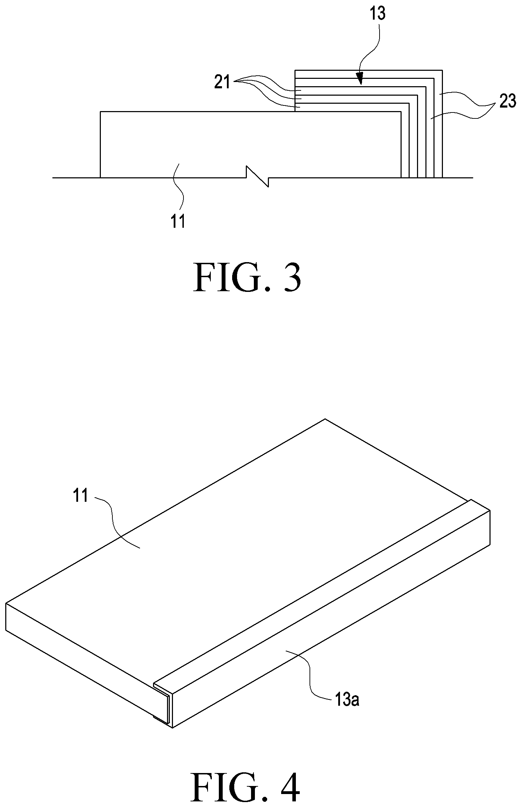

According to various embodiments, the display and/or electronic device 100 may include a printed layer 15 and the signal line 13 may be protected by the printed layer 15. In some embodiments, the printed layer 15 may be used for a procedure for configuring the signal line 13 and may protect the signal line 13 after the signal line 13 has been configured. A description thereof will be given in detail with reference FIG. 4 to FIG. 10. According to an embodiment, although there may be some differences in size and area, the signal line 13 may have a shape substantially corresponding to that of the printed layer 15. For example, unlike the signal line 13 shown in FIG. 1, the shape and arrangement of the signal line 13 in FIG. 1 may substantially correspond to the shape or arrangement of the printed layer 15.

FIG. 3 is a sectional configuration view illustrating a signal line 13 in a line structure (e.g., the line structure 10 in FIG. 1 or FIG. 2) of a display and/or electronic device (e.g., the display and/or electronic device 100 in FIG. 13) according to various embodiments disclosed herein.

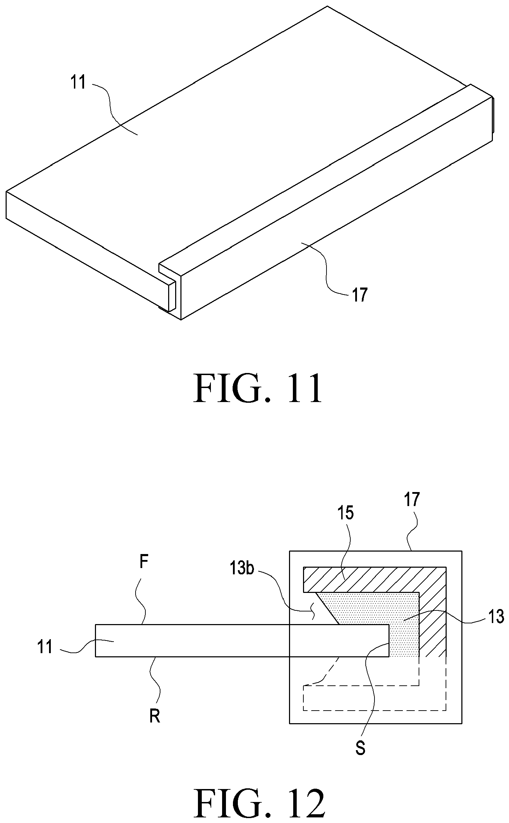

Referring to FIG. 3, the signal line 13 may be disposed on at least one first layer 21 disposed on at least one of a front surface, a rear surface, or the side surface of the substrate 11 and at least one second layer 23 disposed on the first layer 21. The first layer 21 may include, for example, at least one of copper (Cu), silver (Ag), gold (Au), platinum (Pt), or aluminum (Al), and in the display and/or electronic device 100, the signal line 13 may transfer various electrical signals or power substantially through the first layer 21. In some embodiments, the second layer 23 may include at least one of nickel (Ni) or chromium (Cr) and block the first layer 21 from being exposed to the external environment. For example, the second layer 23 blocks the first layer 21 from being exposed to the external environment so as to prevent the first layer 21 from contamination or oxidation. As will be described below, the signal line 13 may be concealed or protected by the printed layer 15 or a protection layer (e.g., the protection layer 17 in FIG. 11 or FIG. 12), and the printed layer 15 of the protection layer 17 may block exposure of the first layer 21. In an embodiment in which the exposure of the first layer 21 is blocked by the printed layer 15 of the protection layer 17, the second layer 23 may be omitted. According to an embodiment, in case that a plurality of first layers 21 are provided, the first layers may be sequentially stacked on a surface (e.g., the side surface S, the front surface F, and/or the rear surface R) of the substrate 11 and a plurality second layers 23 may be sequentially stacked on the first layer 21.

Hereinafter, a procedure in which the signal line 13 is configured will be described with reference to FIG. 4 to FIG. 10.

FIG. 4 is a view illustrating a metal layer 13a for configuring a signal line (e.g., the signal line 13 in FIG. 1 or FIG. 2) of a display and/or electronic device (e.g., the display and/or electronic device 100 in FIG. 13) according to various embodiments disclosed herein.

Referring to FIG. 4, the metal layer 13a may be disposed on an area in which the signal line 13 is to be disposed on the substrate 11, and at least a portion of the metal layer 13a may be configured as the signal line 13. As shown earlier, the metal layer 13a may be disposed on a designated area of the substrate 11 by using at least one of silver (Ag), gold (Au), platinum (Pt) or aluminum (Al) through deposition or plating. In some embodiments, the metal layer 13a may further include one of nickel (Ni) or chromium (Cr). For example, a layer (e.g., the first layer(s) 21 in FIG. 3) including copper, silver, gold, platinum, or aluminum is disposed and then a layer (e.g., the second layer(s) 23 in FIG. 3) including nickel or chromium may be additionally disposed.

According to various embodiments, the metal layer 13a may be disposed on the side surface S, the front surface, and/or the real surface R at an edge of the substrate 11, and the metal layer 13a may not be disposed at a portion of the edge of the front surface F or the rear surface R depending on a design trajectory or pattern of the signal line (e.g., the signal line 13 in FIG. 1 or FIG. 2). For example, a portion of the signal lines 13 shown in FIG. 1 may be disposed on all the front surface F, the side surface S, and the rear surface R, and another portion of the signal lines 13 may be omitted from the front surface F or the rear surface R or disposed only on the side surface S. In some embodiments, selected portions of the signal lines 13 may be electrically connected to each other through a printed pattern which is not shown in the drawing.

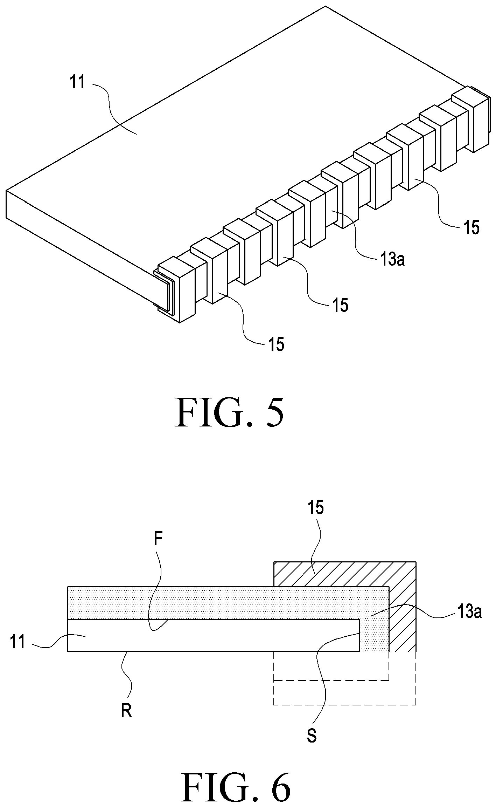

FIG. 5 is a view illustrating an example in which a printed layer 15 or an etching mask is disposed on the metal layer 13a of FIG. 4. FIG. 6 is a sectional configuration view illustrating an example in which a printed layer 15 or an etching mask is disposed on a metal layer 13a of FIG. 4.

Referring to FIG. 5 and FIG. 6, after the metal layer 13a is disposed, the printed layer 15 may be disposed on at least a portion of the metal layer 13a to correspond to a trajectory or pattern of the designed signal line 13. The printed layer 15 may include, for example, materials based on one- or two-component thermal and/or UV curable resins such as acrylic melamine, modified acrylics, modified epoxies, ester-based polyurethanes, etc., and may be produced through printing, painting, vapor deposition or spraying. After the printed layer 15 is disposed and/or the printed layer 15 is cured, the printed layer 15 may become transparent or translucent. For example, the printed layer 15 may transmit at least a portion of visible light. As will be described below, the signal line 13 may be configured by removing a portion of the metal layer 13a by using an etching solution on an area having no printed layer 15 disposed thereon. For example, a material included in the printed layer 15 may be an etch-resistant material.

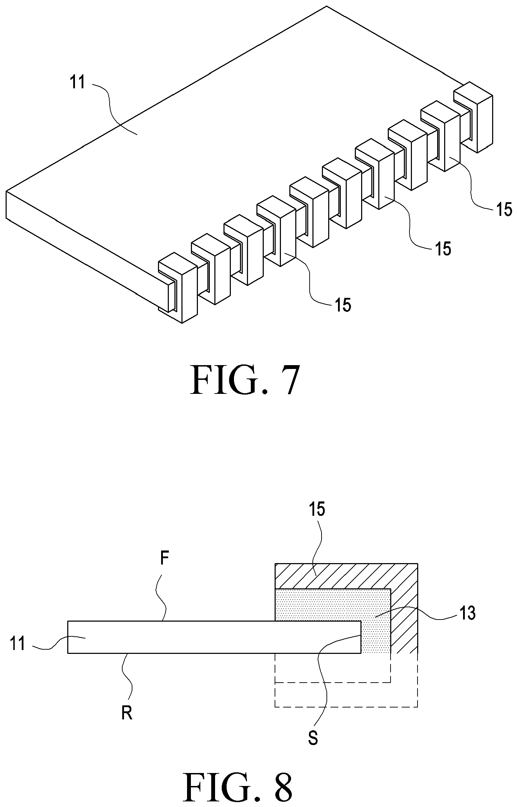

FIG. 7 is a view illustrating an example in which a portion of a metal layer 13a is removed by using a printed layer 15 or an etching mask of FIG. 5.

Referring to FIG. 7, the designed signal line 13 may be configured by removing the metal layer 13a exposed to the outside of the printed layer 15 by using an etching solution after the printed layer 15 is configured. For example, the printed layer 15 may be used substantially as an etching mask and after etching, the metal layer 13a may remain in a portion in which the printed layer 15 is disposed to be provided as the signal line 13. According to a material included in the metal layer 13a, examples of the etching solution may include inorganic compounds such as FeCl_3, inorganic salts such as ceric ammonium nitrate, acidic solutions such as hydrochloric acid or sulfuric acid, alkali solutions such as sodium hydroxide (NaOH) and potassium hydroxide (KOH) alone and/or a material selected from heterogeneous complex solutions such as a complex acid solution, a complex base solution, and two or more homogeneous solutions, or heterogeneous complex solutions such as inorganic compounds and acid complex solutions.

Although some of materials used as the metal layer 13a, the printed layer 15, and/or the etching solution are exemplified in the above-described embodiment, various embodiments disclosed herein are not limited thereto, and other materials known to those skilled in the art may be utilized as the metal layer 13a, the printed layer 15, and/or the etching solution in addition to the materials listed above.

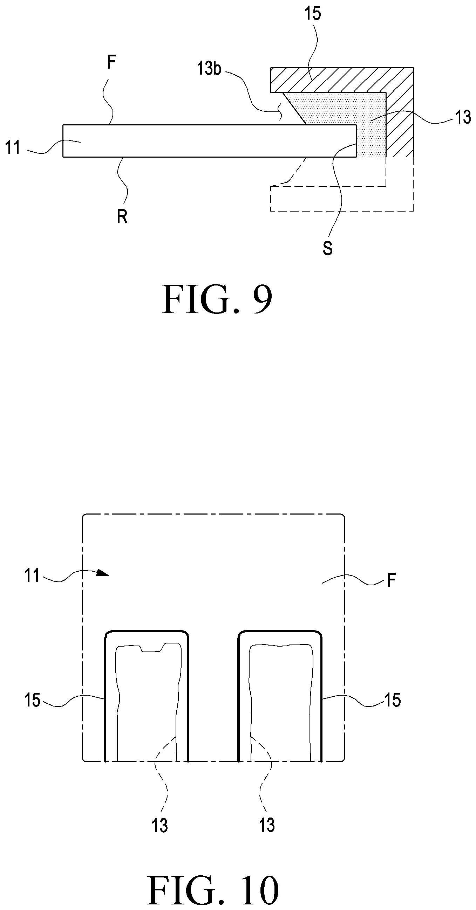

FIG. 8 is a sectional configuration view illustrating a shape in which a signal line 13 of a display and/or electronic device (e.g., the display or electronic device 100 in FIG. 13) is configured according to various embodiments disclosed herein. FIG. 9 is a sectional configuration view illustrating another shape in which a signal line 13 of a display and/or electronic device 100 is configured according to various embodiments disclosed herein.

Referring to FIG. 8, the signal line 13 configured by a remaining metal layer after an exposed portion of the metal layer (e.g., the metal layer 13a in FIG. 4 to FIG. 6) is removed may have a shape substantially corresponding to that of the printed layer 15. For example, the signal line 13 may be covered by the printed layer 15 in a view from the outside of the substrate 11. In an embodiment, in a procedure in which the metal layer 13a is removed by using an etching solution, there may be limitations in controlling or predicting the behavior of the etching solution. In another embodiment, the plating or deposition quality of the metal layer 13a may be partially different. For example, an edge of the signal line 13 in an etching procedure may not coincide with the edge of the printed layer 15 as shown in FIG. 8.

Referring to FIG. 9, depending on the behavior of the etching solution or the plating or deposition quality of the metal layer 13a, a portion of the metal layer 13a may be further removed from the inside of the printed layer 15. For example, an under-cut shape part 13b may be generated between the substrate 11 and the printed layer 15 by removing the signal line 13 further than the edge of the printed layer 15. Although not shown in the drawing, depending on the behavior of the etching solution or the plating or deposition quality of the metal layer 13a, the signal line 13 may include a portion protruding to the outside (e.g., left further than the left end of the printed layer 15 in FIG. 9) of the printed layer 15.

FIG. 10 is a planar view illustrating an example of a printed layer 15 viewed from the outside of a substrate 11 of a display and/or electronic device (e.g., the display or electronic device 100 in FIG. 13) according to various embodiments disclosed herein.

Referring to FIG. 10, after the etching, when viewed from the outside of the substrate 11, the signal line 13 may be configured within an area substantially provided by the printed layer 15. In an embodiment, as described above, depending on the behavior of the etching solution or the plating or deposition quality of the metal layer 13a, the edge of the signal line 13 may have various shapes. In some embodiments, the signal line 13 may include a metal material and may be substantially colored or opaque, and the printed layer 15 may transmit at least a portion of visible light. For example, the signal line 13 may be visually exposed to the outside through the printed layer 15. According to an embodiment, since the signal line 13 is visually exposed to the outside of the printed layer 15, it is possible to identify whether the signal line 13 is defective with the naked eye or using an optical device. As such, a separate electrical test may not be necessary to determine the quality of the signal line 13, and production efficiency or reliability may be improved in the manufacture of the display and/or the electronic device 100.

FIG. 11 is a view illustrating an example in which a protection layer 17 of a display and/or electronic device (e.g., the display or electronic device 100 in FIG. 13) is configured according to various embodiments disclosed herein. FIG. 12 is a sectional configuration view illustrating an example in which a protection layer 17 of a display and/or electronic device 100 is configured according to various embodiments disclosed herein.

Referring to FIG. 11 and FIG. 12, the display and/or electronic device 100 may further include the protection layer 17. The protection layer 17 may include at least one coating layer configured to cover at least a portion of the edge of the substrate 11 and may be configured to at least partially cover the signal line 13 and the printed layer 15. In some embodiments, the protection layer 17 may be configured by multiple coating layers and may be configured to substantially surround the front surface, the rear surface, and the side surface (e.g., the front surface F, the rear surface R, and the side surface S in FIG. 2) at the edge of the substrate 11. In an embodiment, the protection layer 17 may be substantially opaque to improve the light leakage phenomenon in the display and/or electronic device (100) and may provide an impact-absorbing function that protects the substrate 11 by absorbing external impact when the external impact occurs.

FIG. 13 is a view illustrating an electronic device 100 according to various embodiments disclosed herein.

Referring to FIG. 13, the electronic device 100 may include a housing 109 and a display disposed on a surface of the housing 109. For example, in the configuration shown in FIG. 13, components other than the housing 109 may correspond to components constituting the display. In some embodiments, the electronic device 100 itself may correspond to the display.

According to various embodiments, the housing 109 may include coated or colored glass, ceramic, polymer, or a metal (e.g., aluminum, stainless steel (STS), or magnesium), or a combination of at least two thereof. In an embodiment, the display (e.g., the display panel 101) may be visually exposed through a substantial portion of a surface of the housing 109. For example, the display may output a screen through substantially the entirety of one surface of the housing 109.

According to various embodiments, the electronic device 100 and/or display may include a substrate (e.g., the substrate 11 in FIG. 1 or FIG. 2) such as a first circuit board 111, a glass plate 102, and/or a polarization plate 123, and may include a signal line (e.g., the signal line 13 in FIG. 1 or FIG. 2) at least partially disposed on the side surface S of the substrate 11 at the edge of the substrate 11. In that way, a sufficient space for arranging a signal line 13 may be secured while reducing a bezel of the display and/or electronic device 100. This will provide and provide a more extended screen display area, thereby increasing performance corresponding to an ultra-high-definition video service In an embodiment, the electronic device 100 and/or display (e.g., the display panel 101) may include a light-emitting layer 113 disposed on a side or surface of the first circuit board 111 and the polarization plate 123 and/or the glass plate 102 may be disposed to face the first circuit board 111 with the light-emitting layer 113 interposed therebetween. In the embodiment disclosed herein, the polarization plate 123 may be disposed adjacent to the light-emitting layer 113 to face the first circuit board 111 with the light-emitting layer 113 interposed therebetween, and the glass plate 102 may be disposed to face the light-emitting layer 113 with the polarization plate 123 interposed therebetween.

According to various embodiments, the first circuit board 111 and the light-emitting layer 113 may be substantially defined as the display panel 101, and the display panel 101 may further include a protection sheet 115 according to an embodiment. In an embodiment, the first circuit board 111 may include a material such as polyimide, a silica resin, or acryl to have flexibility and may correspond to a multilayer circuit board including a printed circuit pattern. The light-emitting layer 113 may correspond to, for example, a thin film transistor layer stacked on a surface of the first circuit board 111 and may substantially output a screen. For example, the light-emitting layer 113 may receive a control signal through the printed circuit pattern or the signal line (e.g., the signal line 13 in FIG. 1 or FIG. 2) of the first circuit board 111 and output light. The polarization plate 123 may block light which is incident from the outside and reflected from the light-emitting layer 113 or the first circuit board 111. For example, the polarization plate 123 may prevent deterioration of screen quality by blocking reflected light from interfering with light output from the light-emitting layer 113.

According to various embodiments, the protection sheet 115 may be provided to surround the first circuit board 111 to protect the first circuit board 111 and/or the light-emitting layer 113 from the external impact and may prevent another structure from direct contact with the first circuit board 111 and/or the light-emitting layer 113 when the display panel 101 is disposed in the another structure (e.g., the housing 109). In an embodiment, the display panel 101 may be disposed on an internal surface of the glass plate 102. Although not given a reference number, the display panel 101 may be attached on an internal surface of the glass plate 102 by an optical adhesive.

According to various embodiments, in case that the display and/or electronic device 100 includes a touch screen function, a touch sensor pattern 121 may be disposed on a surface of the glass plate 102 or the polarization plate 123. In the embodiment disclosed herein, the configuration in which the touch sensor pattern 121 is disposed on the internal surface of the glass plate 102 is described, and an optical adhesive (or optical adhesive layer) may be provided between the touch sensor pattern 121 and the polarization plate 123.

According to various embodiments, the display and/or electronic device 100 may further include a flexible printed circuit board 131 or 133 bonded to the substrate 11 (e.g., the first circuit board 111 and/or the glass plate 102). For example, the display and/or electronic device 100 may include a first flexible printed circuit board 131 bonded to the substrate 111 first, and a second flexible printed circuit board 133 bonded to the glass plate 102. In an embodiment, the signal line 13 of FIG. 2 may disposed on each of the first circuit board 111 and the glass plate 102, the first flexible printed circuit board 131 may be electrically connected to the signal line 13 of the first circuit board 111, and the second flexible printed circuit board 133 may be electrically connected to the signal line 13 of the glass plate 102. In another embodiment, in case that the touch sensor pattern 121 is disposed on the polarization plate 123, the second flexible printed circuit board 133 may be bonded to the polarization plate 123, and the polarization plate 123 may include a signal line (e.g., the signal line 13 in FIG. 2) for electrically connecting the touch sensor pattern 121 and the second flexible printed circuit board 133.

According to various embodiments, the first flexible printed circuit board 131 may electrically connect the first circuit board 111 to another circuit board (e.g., the second circuit board 103), and a display driving circuit chip (display driving integrated circuit chip) 135a may be disposed on the first flexible printed circuit board 131. In some embodiments, the first flexible printed circuit board 131 may be bonded to the rear surface (e.g., the rear surface R in the substrate in FIG. 2) of the first circuit board 111 to be electrically connected to a signal line (e.g., the signal line 13 in FIG. 2) and/or the light-emitting layer 113. For example, the display driving circuit chip 135a may drive the light-emitting 113 under control of a processor of the electronic device 100. In another embodiment, the first flexible printed circuit board 131 may be bonded to the front surface (e.g., the front surface F in the substrate in FIG. 2) of the first circuit board 111 to be electrically connected to a signal line (e.g., the signal line 13 in FIG. 2) and/or the light-emitting layer 113, and the configuration is indicated by reference numeral "131a" in FIG. 13.

According to various embodiments, the second flexible printed circuit board 133 may be bonded to the glass plate 102 to be electrically connected to the touch sensor pattern 121 through a signal line (e.g., the signal line 13 in FIG. 2). As described above, the touch sensor pattern 121 may be disposed on a surface of the polarization plate 123, and in this case, the second flexible printed circuit board 133 may be electrically connected to the touch sensor pattern 121 through the signal line 13 of the polarization plate 123. In some embodiments, a touch driving circuit chip 135b may be provided on the second flexible printed circuit board 133 and may apply an electrical signal to the touch sensor pattern 123 or recognize an input operation according to a signal detected by the touch sensor pattern 121. Although not shown in the drawing, similar to the first flexible printed circuit board 131, the second flexible printed circuit board 133 may be electrically connected to another circuit board (e.g., the second circuit board 103) or the processor of the electronic device 100, and the touch driving circuit chip 135b may be controlled by the processor and provide a signal detected using the touch sensor pattern 121 to the processor.

In the above-described embodiment, although the configuration in which the display and/or electronic device 100 includes the touch sensor pattern 121 is illustrated, various embodiments disclosed herein are not limited thereto and in video equipment such as televisions, the touch sensor pattern 121 may be omitted. In another embodiment, the above-described line structure (e.g., the line structure 10 in FIG. 1 or FIG. 2) may be included in a personal portable device such as a mobile communication terminal, a smartphone, or a body-wearable electronic device.

According to various embodiments disclosed herein, a display and/or an electronic device (e.g., the display or the electronic device 100 in FIG. 13) including same may include at least one substrate (e.g., the substrate 11 in FIG. 1 to FIG. 12), at least one signal line (e.g., the signal line 13 in FIG. 1 or FIG. 2) which, at the edge of the substrate, is disposed on at least the side surface of the substrate among the front surface, the rear surface, and the side surface (e.g., the front surface F, the rear surface R, or the side surface S in FIG. 2) of the substrate, and a printed layer (e.g., the printed layer 15 in FIG. 2) disposed to cover at least a portion of the signal line at the edge of the substrate, wherein the printed layer is configured to be transparent or translucent so as to visually expose at least a portion of the signal line to the outside (e.g., see FIG. 10) in which the signal line is configured and then defects in the signal line may be identified by using an optical device or the naked eye. In that way, the printed layer contributes to improving the production efficiency or reliability of the signal line, the display, and/or the electronic device.

According to various embodiments, the signal line may be configured to be colored or opaque and configured to penetrate the printed layer, so as to be visually exposed to the outside.

According to various embodiments, in a view from the outside of the substrate, the signal line may be positioned in an area in which the printed layer is disposed.

According to various embodiments, the display and/or electronic device as described above may further include a light-emitting layer (e.g., the light-emitting layer 113 in FIG. 13), the substrate may include a circuit board and a polarization plate (e.g., the first circuit board 111 and the polarization plate 123 in FIG. 13) arranged to face each other with the light-emitting interposed therebetween, and the signal line may be disposed on at least the circuit board among the circuit board and the polarization plate.

According to various embodiments, the light-emitting layer may include a thin film transistor layer and may be electrically connected to the signal line.

According to various embodiments, the signal line may include at least one first layer (e.g., the first layer 21 in FIG. 3) disposed on at least one of a front surface, a rear surface, or the side surface of the substrate and at least one second layer (e.g., the second layer 23 in FIG. 3) disposed on the first layer, the first layer may include at least one of copper (Cu), silver (Ag), gold (Au), platinum (Pt), or aluminum (Al), and the second layer may include at least one of nickel (Ni) or chromium (Cr).

According to various embodiments, multiple first layers may be sequentially stacked on a surface of the substrate.

According to various embodiments, the signal line may include a first part disposed on the side surface and a second part electrically connected to the first part and disposed on at least one of the front surface and the rear surface.

According to various embodiments, the printed layer may include at least one of acrylic melamine, modified acrylic, modified epoxy, ester-based polyurethane, a thermosetting resin, or an ultraviolet curable resin.

According to various embodiments, the display and/or electronic device as described above may further include a protection layer (e.g., the protection layer 17 in FIG. 11 or FIG. 12) disposed on at least a portion of the edge of the substrate, and the protection layer may be configured to cover the signal line or the printed layer.

According to various embodiments, the display and/or electronic device as described above may further include a flexible printed circuit board (e.g., the flexible printed circuit board 131 or 133 in FIG. 13) bonded to the substrate, and the flexible printed circuit board may be electrically connected to the signal line.

According to various embodiments, the display and/or electronic device as described above may further include a light-emitting layer, the substrate may include a circuit board disposed on a side of the light-emitting layer, a polarization plate disposed to face the circuit board with the light-emitting layer interposed therebetween, and a glass plate (e.g., the glass plate 102 in FIG. 13) disposed to face the light-emitting layer with the polarization plate interposed therebetween, and the signal line may include a first line (e.g., the signal line 13 disposed on the first circuit board 111 and electrically connected to the light-emitting layer 113 in FIG. 13) disposed on the circuit board and electrically connected to the light-emitting layer and a second line (e.g., the signal line 13 disposed on the glass plate 102 and electrically connected to the touch sensor pattern 121 in FIG. 13) disposed on at least one of the polarization plate and the glass plate.

According to various embodiments, the display and/or electronic device as described above may further include a first flexible printed circuit board (e.g., the first flexible printed circuit board 131 in FIG. 13) bonded to the circuit board and electrically connected to the first line and a second flexible printed circuit board (e.g., the second flexible printed circuit board 133 in FIG. 13) bonded to one of the polarization plate and the glass plate and electrically connected to the second line.

According to various embodiments disclosed herein, an electronic device (e.g., the display or the electronic device 100 in FIG. 13) may include a housing (e.g., the housing 109 in FIG. 13) and a display disposed on a surface of the housing, and the display may include at least one substrate (e.g., the substrate 11 in FIG. 1 to FIG. 12), at least one signal line (e.g., the signal line 13 in FIG. 1 or FIG. 2) which, at the edge of the substrate, is disposed on at least the side surface of the substrate among the front surface, the rear surface, and the side surface (e.g., the front surface F, the rear surface R, or the side surface S in FIG. 2) of the substrate, and a printed layer (e.g., the printed layer 15 in FIG. 2) disposed to cover at least a portion of the signal line at the edge of the substrate, wherein the printed layer is configured to be transparent or translucent so as to visually expose at least a portion of the signal line to the outside.

According to various embodiments, the signal line may be configured to be colored or opaque and configured to penetrate the printed layer, so as to be visually exposed to the outside.

According to various embodiments, in a view from the outside of the substrate, the signal line may be positioned in an area in which the printed layer is disposed.

According to various embodiments, the display may further include a protection layer (e.g., the protection layer 17 in FIG. 11 or FIG. 12) disposed on at least a portion of the edge of the substrate, and the protection layer may be configured to cover the signal line or the printed layer.

According to various embodiments, the display may further include a flexible printed circuit board (e.g., the flexible printed circuit board 131 or 133 in FIG. 13) bonded to the substrate, and the flexible printed circuit board may be electrically connected to the signal line.

According to various embodiments, the substrate may include a circuit board (e.g., the first circuit board 111 in FIG. 13), a polarization plate (e.g., the polarization plate 123 in FIG. 13) disposed to face the circuit board with a light-emitting layer (e.g., the light-emitting layer 113 in FIG. 13) interposed therebetween, and a glass plate (e.g., the glass plate 102 in FIG. 13) disposed to face the light-emitting layer with the polarization plate interposed therebetween, and the signal line may be disposed on the circuit board and electrically connected to the light-emitting layer.

According to various embodiments, the display may further include a flexible printed circuit board bonded to the circuit board and electrically connected to the signal line and a driving circuit chip (driving integrated circuit chip) (e.g., the driving circuit chip 135a or 135b in FIG. 13) disposed on the flexible printed circuit board and electrically connected to the signal line.

As mentioned above, in the detailed description of the disclosure, specific embodiments have been described, but it will be apparent to those of ordinary skill in the art that various modifications are possible without departing from the scope of the disclosure.

## Claims

1. A display comprising:
at least one substrate;
at least one signal line disposed on at least one of a front surface, a rear surface, or the side surface of the substrate, and at an edge of the substrate; and
a printed layer disposed to cover at least a portion of the signal line, at the edge of the substrate,
wherein the printed layer is configured to be transparent or translucent so as to visually expose at least a portion of the signal line to the outside.

2. The display of claim 1, wherein the signal line is configured to be colored or opaque, and configured to penetrate the printed layer so as to be visually exposed to the outside.

3. The display of any one of claims 1 or 2, wherein in a view from the outside of the substrate, the signal line is positioned in an area in which the printed layer is disposed.

4. The display of any one of the preceding claims, further comprising a light-emitting layer,
wherein the substrate comprises a circuit board and a polarization plate disposed to face each other with the light-emitting layer interposed therebetween, and
wherein the signal line is disposed on at least the circuit board among the circuit board and the polarization plate.

5. The display of claim 4, wherein the light-emitting layer comprises a transistor layer and is electrically connected to the signal line.

6. The display of any one of the preceding claims, wherein the signal line comprises:
at least one first layer disposed on at least one of a front surface, a rear surface, or
the side surface of the substrate; and
at least one second layer disposed on the first layer, and
wherein the first layer comprises at least one of copper, Cu, silver, Ag, gold, Au, platinum, Pt, or aluminum, Al, and the second layer comprises at least one of nickel, Ni, or chromium, Cr.

7. The display of claim 6, wherein the signal line comprises a plurality of first layers and wherein the plurality of first layers are sequentially stacked on said surface of the substrate.

8. The display of any one of the preceding claims, wherein the signal line comprises a first part disposed on the side surface and a second part electrically connected to the first part and disposed on at least one of the front surface and the rear surface.

9. The display of any one of the preceding claims, wherein the printed layer comprises at least one of acrylic melamine, modified acrylic, modified epoxy, ester-based polyurethane, a thermosetting resin, or an ultraviolet curable resin.

10. The display of any one of the preceding claims, further comprising a protection layer disposed on at least a portion of the edge of the substrate,
wherein the protection layer is configured to cover the signal line or the printed layer.

11. The display of any one of the preceding claims, further comprising a flexible printed circuit board bonded to the substrate,
wherein the flexible printed circuit board is electrically connected to the signal line.

12. The display of any one of the preceding claims, further comprising a light-emitting layer,
wherein the substrate comprises:
a circuit board disposed on a side of the light-emitting layer;
a polarization plate disposed to face the circuit board with the light-emitting layer interposed therebetween; and
a glass plate disposed to face the light-emitting layer with the polarization plate interposed therebetween, and
wherein the signal line comprises:
a first line disposed on the circuit board and electrically connected to the light-emitting layer; and
a second line disposed on at least one of the polarization plate and the glass plate.

13. The display of claim 12, further comprising:
a first flexible printed circuit board bonded to the circuit board and electrically connected to the first line; and
a second flexible printed circuit board bonded to one of the polarization plate and the glass plate and electrically connected to the second line.

14. An electronic device comprising:
a housing; and
a display which is disposed on a surface of the housing and corresponds to the display according to one of claim 1 to claim 13.

15. The electronic device of claim 14, further comprising a protection sheet provided to surround at least a portion of the substrate.
